# EUROPEAN PATENT APPLICATION

(11) **EP 2 383 780 A1**
(43) Date of publication of application: **02.11.2011**
(21) Application number: 10172281.7
(22) Date of filing: 09.08.2010
(51) Int. Cl.: H01L 25/075, H01S 5/042, H01L 33/60, H01L 33/46, H01L 33/40

(54) **Light emitting devices**

(30) Priority: 27.04.2010 US 768679
(71) Applicant: Intematix Technology Center Corporation, Taoyuang 32661 (TW)
(72) Inventor: Chou, Hsi-yan, Taipei (TW)
(74) Representative: 2K Patentanwälte Blasberg Kewitz & Reichel

(57) **Abstract**

A light emitting device includes a number of light emitting clips (28), a substrate to support (20) the light emitting chips (28), a patterned first conductive layer (23) over the substrate (20) to facilitate radiation and reflection of light from the light emitting chips (28), and a patterned second conductive layer (24) on the patterned first conductive layer (23), wherein the light emitting chips are located on the patterned second conductive layer, and a reflective layer (33) on the patterned first conductive layer, exposing the patterned second conductive layer.

## Description

### BACKGROUND OF THE INVENTION

The present invention generally relates to an optoelectronic device and, more particularly, to a light emitting device.

A light emitting device may include light emitting units arranged over a substrate. Between the light-emitting units and the substrate, a conductive layer may be provided for conducting power to and therefore activating the light-emitting units. Furthermore, the conductive layer may include separate regions for mounting the light-emitting units and conductive wires thereon. Moreover, the conductive layer may reflect the beams of light emitted by the light-emitting units, as will be discussed below.

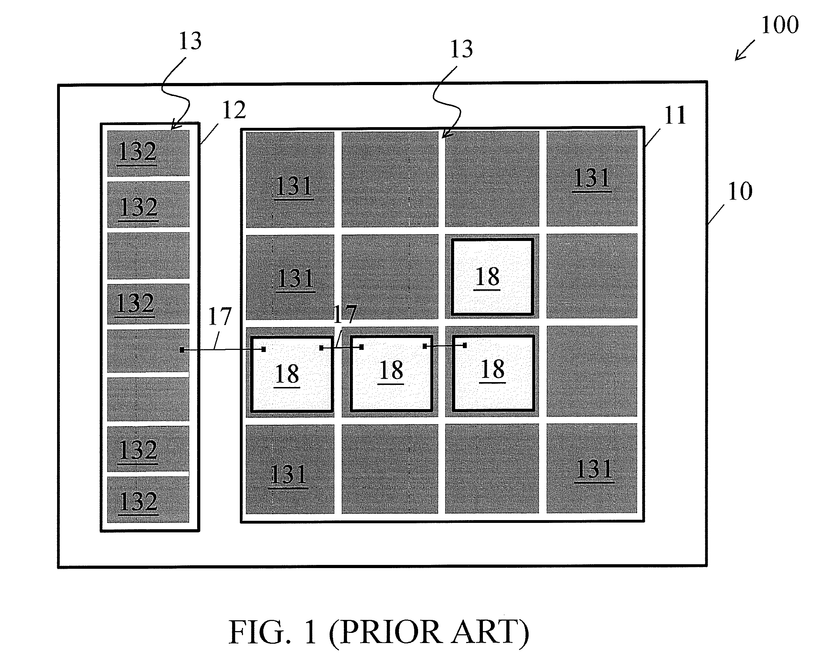

FIG. 1 is a schematic plan view of a light emitting device 100 in prior art. Referring to FIG. 1, the light emitting device 100 may include a substrate 10, a die attachment region 11 and a wire bond region 12 defined over the substrate 10, and a patterned conductive layer 13. The patterned conductive layer 13 may include first pads 131 in the die attachment region 11 and second pads 132 in the wire bond region 12. At least one chip or die 18 each serving as a light emitting unit of the light emitting device 100 may be attached to the first pads 131 and electrically interconnected with each other or electrically coupled by wires 17 to the second pads 132 in order for electrical connection with external circuits.

In general, the first and second pads 131 and 132 of the patterned conductive layer 13 may be formed of gold (Au) or silver (Ag). Au may exhibit good bonding reliability for die attachment and wire bond. However, Au may not provide high reflectivity over the spectrum of visible light. By contrast, silver (Ag) may exhibit relatively high reflectivity in the full spectrum of visible light. Nevertheless, Ag may suffer sulfurization, which may adversely affect the reflectivity. Moreover, Ag may be subject to a migration issue, which may lead to short-circuiting in the light emitting device 100.

It may therefore be desirable to have a light emitting device that has a reliable bonding ability and a durable reflectivity.

### BRIEF SUMMARY OF THE INVENTION

Examples of the present invention may provide a light emitting device that comprises a substrate, a patterned first conductive layer over the substrate, wherein the patterned first conductive layer is formed of aluminum (Al), a pattern second conductive layer on the patterned first conductive layer, wherein the patterned second conductive layer is formed of a material selected from one of gold (Au) and silver (Ag), and a reflective layer on the patterned first conductive layer, exposing the patterned second conductive layer.

Some examples of the present invention may provide a light emitting device that comprises a number of light emitting chips, a substrate to support the light emitting chips, a patterned first conductive layer over the substrate to facilitate radiation and reflection of light from the light emitting chips, and a pattern second conductive layer on the patterned first conductive layer, wherein the light emitting chips are located on the patterned second conductive layer.

Examples of the present invention may also provide a light emitting device that comprises a substrate including a first region and a second region, the first and second regions located immediately adjacent to each other, a number of first units in the first region to facilitate radiation and reflection of light, a number of second units in the second region to facilitate radiation and reflection of light, a number of first pads on the first units, a number of second pads on the second units, and a number of light emitting chips on the second pads.

Additional features and advantages of the present invention will be set forth in portion in the description which follows, and in portion will be obvious from the description, or may be learned by practice of the invention. The features and advantages of the invention will be realized and attained by means of the elements and combinations particularly pointed out in the appended claims.

It is to be understood that both the foregoing general description and the following detailed description are exemplary and explanatory only and are not restrictive of the invention as claimed.

### BRIEF DESCRIPTION OF THE SEVERAL VIEWS OF THE DRAWINGS

The foregoing summary, as well as the following detailed description of the invention, will be better understood when read in conjunction with the appended drawings. For the purpose of illustrating the invention, examples are shown in the drawings. It should be understood, however, that the invention is not limited to the precise arrangements and instrumentalities shown in the examples.

In the drawings:

FIG. 1 is a schematic plan view of a light emitting device in prior art;

FIG. 2A is a schematic plan view of a light emitting device in accordance with an example of the present invention;

FIG. 2B is a schematic perspective view of a light emitting chip illustrated in FIG. 2A;

FIG. 2C is a schematic cross-sectional view of the light emitting device illustrated in FIG. 2A;

FIG. 3A is a schematic plan view of a light emitting device in accordance with another example of the present invention;

FIG. 3B is a schematic perspective view of a light emitting chip illustrated in FIG. 3A;

FIG. 3C is a schematic cross-sectional view of the light emitting device illustrated in FIG. 3A;

FIG. 4A is a schematic plan view of a light emitting device in accordance with still another example of the present invention;

FIG. 4B is a schematic cross-sectional view of the light emitting device illustrated in FIG. 4A;

FIG. 5A is a schematic plan view of a light emitting device in accordance with yet another example of the present invention; and

FIG. 5B is a schematic cross-sectional view of the light emitting device illustrated in FIG. 5A.

### DETAILED DESCRIPTION OF THE INVENTION

Reference will now be made in detail to the present examples of the invention illustrated in the accompanying drawings. Wherever possible, the same reference numbers will be used throughout the drawings to refer to the same or like portions. It should be noted that the drawings are in greatly simplified form and are not to precise scale.

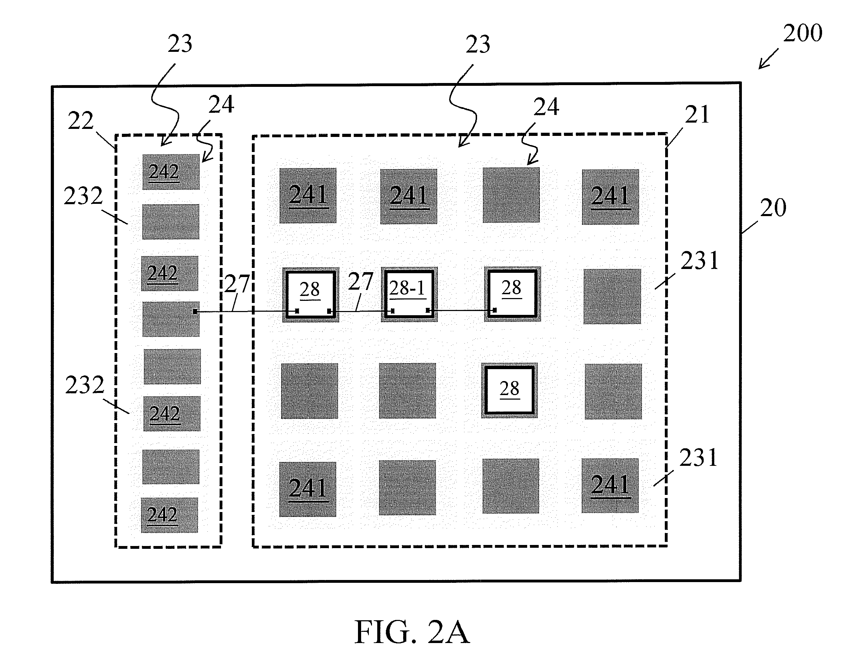

FIG. 2A is a schematic plan view of a light emitting device 200 in accordance with an example of the present invention. Referring to FIG. 2A, the light emitting device 200 may include a substrate 20, a patterned first conductive layer 23 over the substrate 20, a patterned second conductive layer 24 on the patterned first conductive layer 23, and a number of light emitting dies or chips 28 on the patterned second conductive layer 24.

The substrate 20 may serve as a base or carrier that supports the light emitting chips 28. In one example, the substrate 20 may include but is not limited to a printed circuit board (PCB) or lead frame, and may be formed of a material selected from one or more of silicon, ceramic, flame-retardant 4 (FR4), glass and metal.

The patterned first conductive layer 23 may be formed of a material with a predetermined or relatively high reflectivity. The predetermined reflectivity may be high enough to facilitate radiation and reflection of light from the light emitting device 200. In one example according to the present invention, the patterned first conductive layer 23 may include aluminum (Al), the reflectivity of which may be 70% or higher. Moreover, the patterned first conductive layer 23 may include a number of first reflecting units 231 in a first region 21 of the substrate 20 and a number of second reflecting units 232 in a second region 22 of the substrate 20. The first and second regions 21 and 22, which may be located immediately adjacent to each other or contiguous with each other, may together define a reflective region for the light emitting device 200. In one example, the second region 22 may surround the first region 21.

The patterned second conductive layer 24 may be formed of a material with a relatively reliable bonding ability. In one example according to the present invention, the patterned second conductive layer 24 may include gold (Au) or silver (Ag). Moreover, the patterned second conductive layer 24 may include a number of first pads 241 on the first reflecting units 231 and a number of second pads 242 on the second reflecting units 232. The first pads 241 may each serve as a base for die attachment with one of the light emitting chips 28. Furthermore, the second pads 242 may each serve as a base for a wire bond.

The light emitting chips 28 may each include a light emitting diode (LED) or a laser diode (LD) and may be mounted to the first pads 241 in a die attaching process. Specifically, each of the chips 28 may be mounted to a corresponding one of the first pads 241 using an adhesive, often epoxy-based conductive adhesives, solder, solder paste or eutectic alloys. Furthermore, some of the chips 28 may be electrically connected with at least one of the second pads 242 via a conductive wire 27 such as a gold wire in a wire bonding process.

In the present example, the light emitting device 200 includes a number of chips 28 arranged in a matrix. Each of the chips 28 may have been packaged in a chip-scale package level. In other examples, however, the light emitting device 200 may include a single chip such as an LED or LD in a chip-scale package.

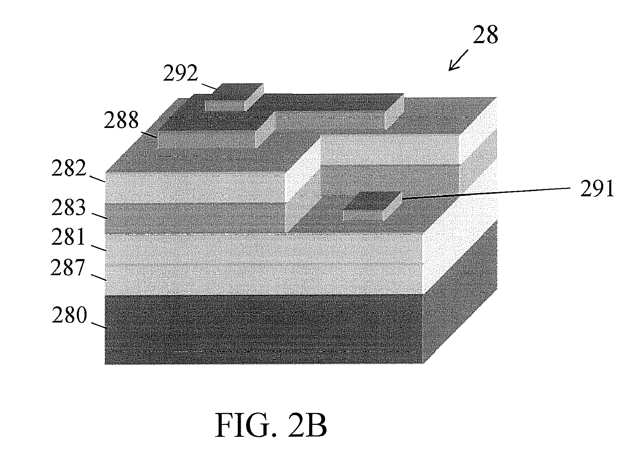

FIG. 2B is a schematic perspective view of the chip 28 illustrated in FIG. 2A. Referring to FIG. 2B, the chip 28 may include a substrate 280, an n-type doped layer 281 on or over the substrate 280, a p-type doped layer 282 over the n-type doped layer 281, an active layer 283 between the n-type doped layer 281 and the p-type doped layer 282, a first electrode 291 on the n-type doped layer 281 and a second electrode 292 on or over the p-type doped layer 282.

The substrate 280 of the chip 28 may include one of a sapphire, silicon, silicon carbide, germanium, zinc oxide (ZnO) or gallium arsenide, depending on the composition of the LED layers to be deposited. In one example, the chip 28 may include a gallium nitride (GaN) LED grown on a sapphire substrate.

Optionally, an undoped layer 287, which may include undoped GaN, may be deposited on the substrate 280. The n-type doped layer 281, which may include n-type doped GaN, may be disposed on the substrate 280 (if the undoped layer 287 is not present) or on the undoped layer 287 (if it is present).

The active layer 283 may be deposited on the n-type doped layer 281 and may serve as a multiple quantum well (MQW, where photon generation occurs when the diode is properly biased. Current may flow from the second electrode 292 via the active layer 283 toward the first electrode 291. The chip 28 may be termed a "lateral LED" because the current flows laterally across the chip 28.

The p-type doped layer 282, which may include p-type doped GaN, may be formed on the active layer 283. However, the conductivity of some p-type doped layers may be undesirable. As a result, optionally, a semi-transparent conductive coating 288 may be applied on the p-type doped layer 282. The conductive coating 288 in one example may include an alloy of nickel and gold (Ni/Au) or indium tin oxide (ITO), which may serve as a contact layer that facilitates the dispersion of current.

The first electrode 291 may be formed on the n-type doped layer 281 for external electrical connection. Furthermore, the second electrode 292 may be formed on the p-type doped layer 282 (if the conductive coating 288 is not present) or on the conductive coating 288 (if it is present) for external electrical connection.

Referring back to FIG. 2A, the chips 28 may be electrically interconnected by wires 27 in a fashion that the first electrode 291 of one chip such as an exemplary chip 28-1 is coupled via wire 27 to the second electrode 292 of another chip (in the current example a subsequent chip), and the second electrode 292 of the exemplary chip 28-1 is coupled to the first electrode 291 of yet another chip (in the current example a previous chip).

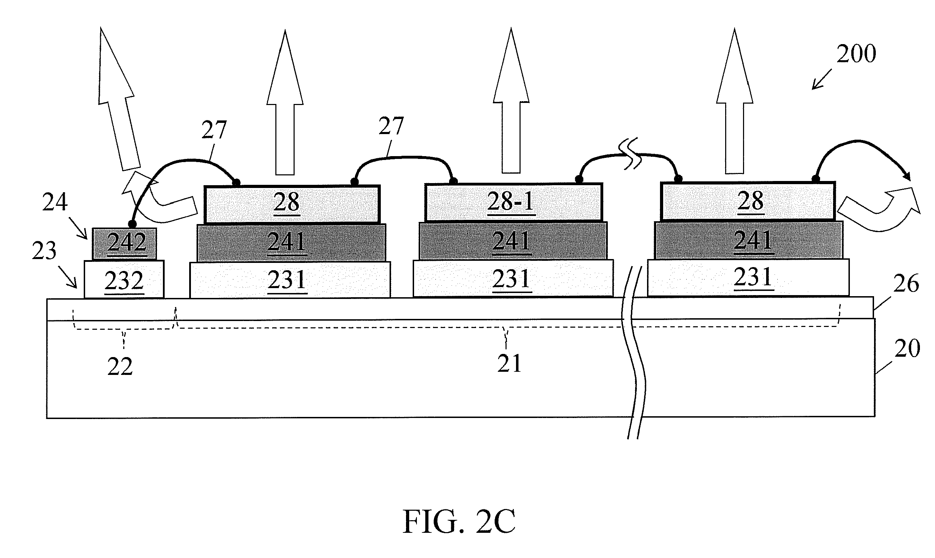

FIG. 2C is a schematic cross-sectional view of the light emitting device 200 illustrated in FIG. 2A. Referring to FIG. 2C, to manufacture the light emitting device 200, the patterned first conductive layer 23 may be formed on, for example, an insulating layer 26 of the substrate 20 by a suitable process, which may include but is not limited to one of a deposition, sputtering, electroplating and electroless plating process followed by an etching process. Next, the patterned second conductive layer 24 may be formed on the patterned first conductive layer 23 by a similar process. The light emitting chips 28 may then be attached to the first pads 241 of the patterned second conductive layer 24 by a die attaching process. Subsequently, the chips 28 may be electrically connected to the second pads 242 of the patterned second conductive layer 24 by a wire bonding process.

Light radiated by the light emitting device 200 may include light emitted from the light emitting chips 28 and light reflected by the patterned first conductive layer 23. The relatively high reflective material in the first reflecting units 231 and the second reflecting units 232 of the patterned first conductive layer 23 may facilitate radiation and reflection of light, as shown in broad arrows.

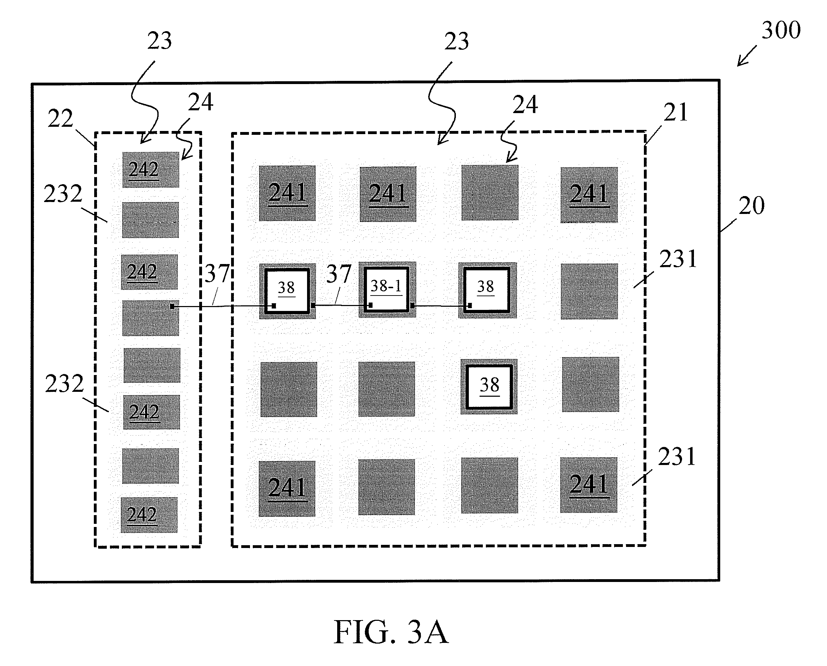

FIG. 3A is a schematic plan view of a light emitting device 300 in accordance with another example of the present invention. Referring to FIG. 3A, the light emitting device 300 may be similar to the light emitting device 200 described and illustrated with reference to FIG. 2A except that, for example, "vertical" chips" 38 replace the lateral chips 28.

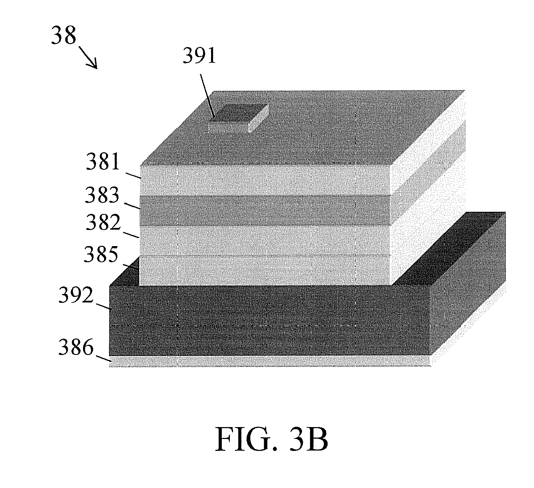

FIG. 3B is a schematic perspective view of the light emitting chip 38 illustrated in FIG. 3A. Referring to FIG. 3B, the chip 38 may include a conductive base 392, a p-type doped layer 382 on or over the conductive base 392, an n-type doped layer 381 over the p-type doped layer 382, an active layer 383 between the p-type doped layer 382 and the n-type doped layer 381, and a first electrode 391.

The n-type doped layer 381, which may include n-type GaN or a combination of undoped GaN and n-GaN, may be deposited on a sacrifice substrate (not shown).

The active layer 383 to serve as a multiple quantum well may be grown on the n-type doped layer 381. The p-type doped layer 382, which may include p-GaN, may be deposited on the active layer 383.

A reflecting layer 385 may optionally be formed on the p-type doped layer 382. The reflecting layer 385 may prevent photons from traveling beyond the semiconductor layers 381, 382 and 383 and into the conductive base 392 for absorption.

The conductive base 392, which may include a thick metal layer, may be formed on the reflecting layer 385 (if it is present) or on the p-type doped layer 382 (if the reflecting layer 385 is not present). The conductive base 392 may serve as a second electrode for the chip 38. Accordingly, current may flow vertically from the second electrode 392 via the active layer 383 toward the first electrode 391. Optionally, an additional conductive layer 386 may be added onto the conductive base 392 to improve the contact resistance and the p-electrode integrity. Subsequently, the sacrifice substrate may be removed, the entire structure is flipped, and the first electrode 391 may then be formed on the n-type doped layer 381.

Referring back to FIG. 3A, the chips 38 may be electrically interconnected by wires 37 in a fashion that the first electrode 391 of one chip such as an exemplary chip 38-1 is coupled via wire 37 to the second electrode 392 of another chip (in the current example a previous chip), and the second electrode 392 of the exemplary chip 38-1 is coupled to the first electrode 391 of yet another chip (in the current example a subsequent chip).

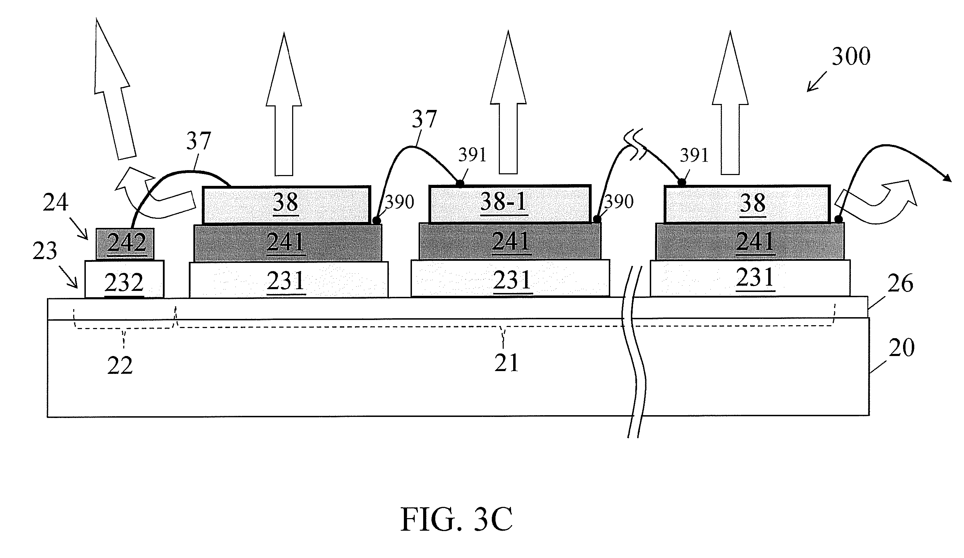

FIG. 3C is a schematic cross-sectional view of the light emitting device 300 illustrated in FIG. 3A. Referring to FIG. 3C, wire 37 that electrically interconnects two adjacent chips 38 may include one end bonded to the first electrode 391 of one of the two chips 38 and the other end bonded to a point 390 on the first pad 241 electrically coupled with the second electrode 392 of the other one of the two chips 38.

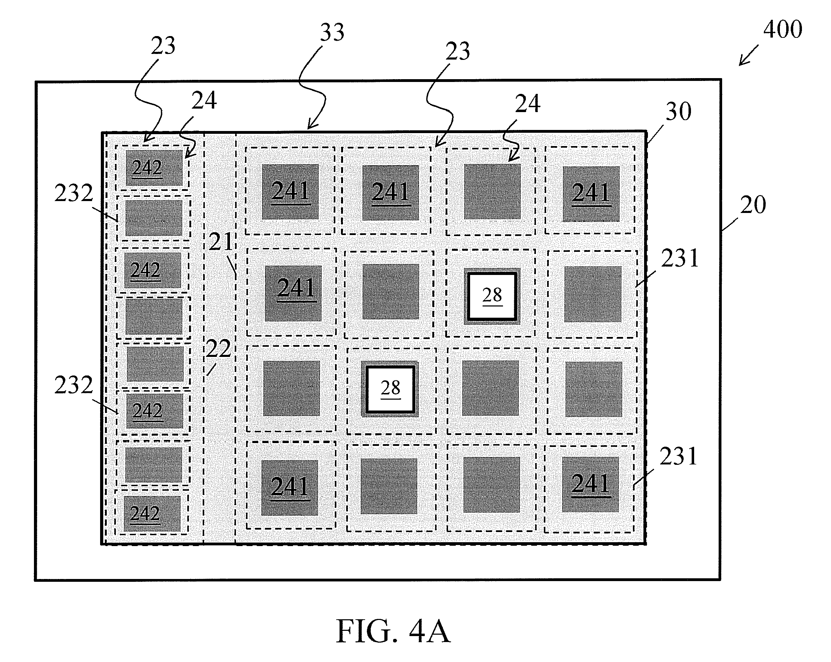

FIG. 4A is a schematic plan view of a light emitting device 400 in accordance with still another example of the present invention. Referring to FIG. 4A, the light emitting device 400 may be similar to the light emitting device 200 described and illustrated with reference to FIG. 2A except that, for example, a reflective layer 33 may be formed on the patterned first conductive layer 23 in a reflective region 30 defined by the first and second regions 21 and 22.

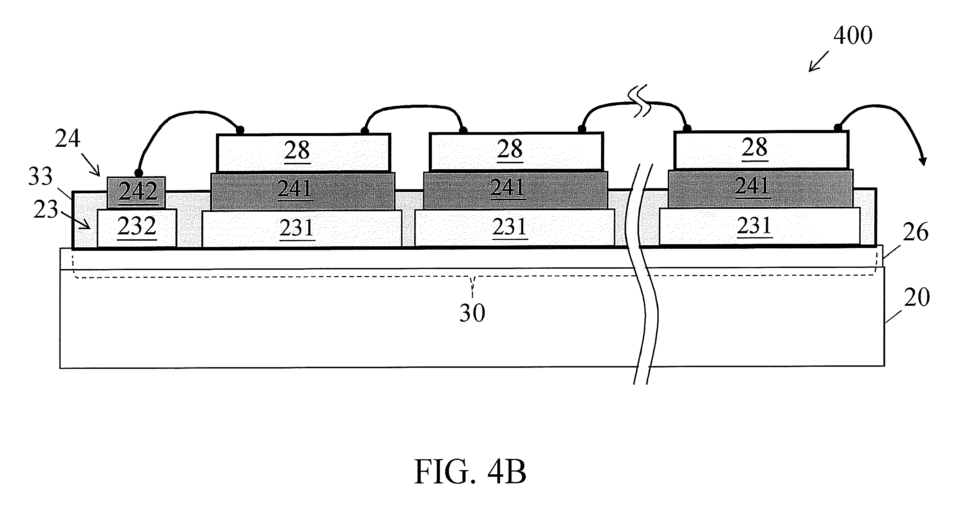

FIG. 4B is a schematic cross-sectional view of the light emitting device 400 illustrated in FIG. 4A. Referring to FIG. 4B, the reflective layer 33 may be formed on the patterned first conductive layer 23 by, for example, a coating process, exposing the first pads 241 and the second pads 242 of the patterned second conductive layer 24. The reflective layer 33 may include a material of a relatively high reflectivity. In one example according to the present invention, the reflective layer 33 may include one of magnesium oxide (MgO) and barium sulfate (BaSO₂), whose reflectivity may be 90% or more. Moreover, in the case that the patterned first conductive layer 23 is formed of aluminum (Al), the reflective layer 33 of MgO or BaSO₂ may raise the total reflectivity of the light emitting device from approximately 70% to 80%.

Although lateral chips 28 are illustrated as an example, skilled persons in the art will understand that the light emitting device 400 may also be applicable to vertical chips 38 described and illustrated with reference to FIG. 3B.

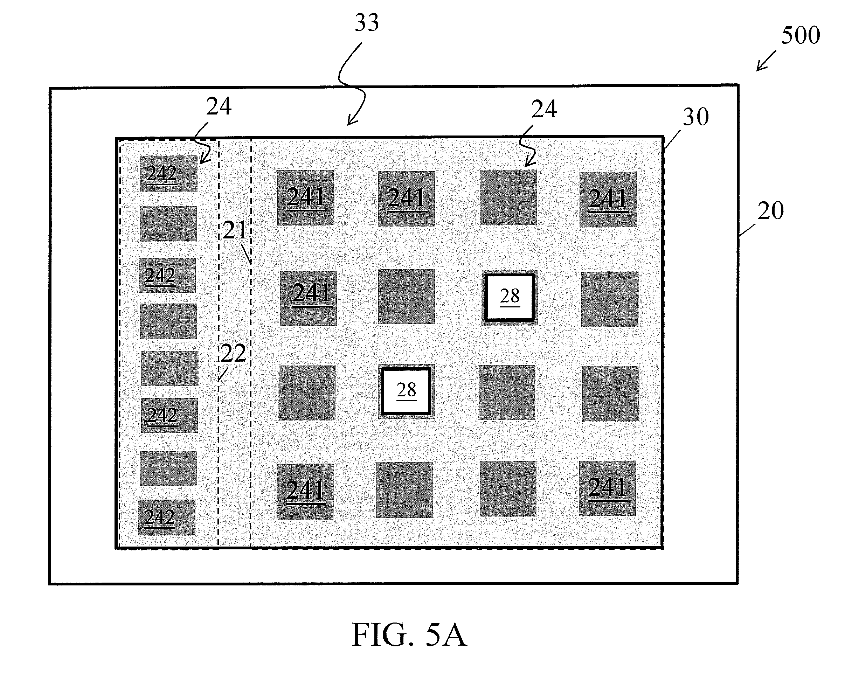

FIG. 5A is a schematic plan view of a light emitting device 500 in accordance with yet another example of the present invention. Referring to FIG. 5A, the light emitting device 500 may be similar to the light emitting device 400 described and illustrated with reference to FIG. 4A except that, for example, the patterned first conductive layer 23 in the light emitting device 400 may be removed.

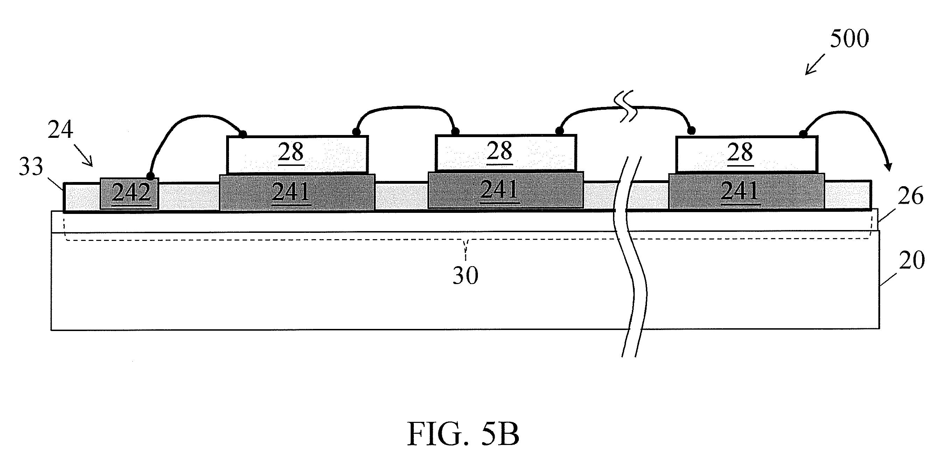

FIG. 5B is a schematic cross-sectional view of the light emitting device 500 illustrated in FIG. 5A. Referring to FIG. 5B, the patterned second conductive layer 24 may be formed on the insulating layer 26. Furthermore, the reflective layer 33 may be formed on the insulating layer 26, exposing the first and second pads 241 and 242 of the patterned second conductive layer 24. Accordingly, the reflective layer 33 may serve as a reflective region for the light emitting device 500.

Although lateral chips 28 are illustrated as an example, skilled persons in the art will understand that the light emitting device 500 may also be applicable to vertical chips 38 described and illustrated with reference to FIG. 3B.

It will be appreciated by those skilled in the art that changes could be made to the examples described above without departing from the broad inventive concept thereof. It is understood, therefore, that this invention is not limited to the particular examples disclosed, but it is intended to cover modifications within the spirit and scope of the present invention as defined by the appended claims.

Further, in describing representative examples of the present invention, the specification may have presented the method and/or process of the present invention as a particular sequence of steps. However, to the extent that the method or process does not rely on the particular order of steps set forth herein, the method or process should not be limited to the particular sequence of steps described. As one of ordinary skill in the art would appreciate, other sequences of steps may be possible. Therefore, the particular order of the steps set forth in the specification should not be construed as limitations on the claims. In addition, the claims directed to the method and/or process of the present invention should not be limited to the performance of their steps in the order written, and one skilled in the art can readily appreciate that the sequences may be varied and still remain within the spirit and scope of the present invention.

## Claims

1. A light emitting device comprising:
a substrate;
a patterned first conductive layer over the substrate, wherein the patterned first conductive layer is formed of aluminum (Al);
a patterned second conductive layer on the patterned first conductive layer, wherein the patterned second conductive layer is formed of a material selected from one of gold (Au) and silver (Ag); and
a reflective layer on the patterned first conductive layer, exposing the patterned second conductive layer.

2. The light emitting device of claim 1, wherein the reflective layer includes a material selected from one of magnesium oxide and barium sulfate.

3. The light emitting device of claim 1, wherein the patterned first conductive layer includes a number of first units located in a first region of the substrate and a number of second units located in a second region of the substrate.

4. The light emitting device of claim 3, wherein the patterned second conductive layer includes a number of first pads on the first units of the patterned first conductive layer and a number of second pads on the second units of the patterned first conductive layer.

5. The light emitting device of claim 4 further comprising a number of light emitting chips on the first pads of the patterned second conductive layer.

6. The light emitting device of claim 5, wherein each of the light emitting chips includes one of a light emitting diode (LED) and a laser diode (LD).
